(19) Europäisches Patentamt
European Patent Office
Office européen des brevets

(11) **EP 3 502 289 B1**

(12) **FASCICULE DE BREVET EUROPEEN**

(45) Date de publication et mention de la délivrance du brevet:
**09.11.2022 Bulletin 2022/45**

(21) Numéro de dépôt: **17209690.1**

(22) Date de dépôt: **21.12.2017**

(51) Classification Internationale des Brevets (IPC):
**G04B 17/06** (2006.01)  **G04B 17/22** (2006.01)
**G04B 43/00** (2006.01)  **C22F 1/18** (2006.01)
**C22C 14/00** (2006.01)  **C22C 27/02** (2006.01)

(52) Classification Coopérative des Brevets (CPC):
**G04B 17/066; C22C 14/00; C22C 27/02; C22F 1/18; G04B 17/227; G04B 43/007**

(54) **PROCÉDÉ DE FABRICATION D'UN RESSORT SPIRAL POUR MOUVEMENT D'HORLOGERIE**

HERSTELLUNGSVERFAHREN EINER SPIRALFEDER FÜR UHRWERK

MANUFACTURING METHOD OF A HAIRSPRING FOR A TIMEPIECE MOVEMENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**26.06.2019 Bulletin 2019/26**

(73) Titulaire: **Nivarox-FAR S.A.**
**2400 Le Locle (CH)**

(72) Inventeur: **CHARBON, Christian**
**2054 Chézard-St-Martin (CH)**

(74) Mandataire: **ICB SA**
**Faubourg de l'Hôpital, 3**
**2001 Neuchâtel (CH)**

(56) Documents cités:
**EP-A1- 1 039 352**  **EP-A1- 2 696 381**
**EP-A2- 1 083 243**  **WO-A2-2005/045532**
**WO-A2-2015/189278**  **GB-A- 503 070**
**GB-A- 1 166 701**  **JP-A- H04 279 212**

**Description**

Domaine de l'invention

L'invention concerne un procédé de fabrication d'un ressort spiral destiné à équiper un balancier d'un mouvement d'horlogerie.

Arrière-plan de l'invention

La fabrication de ressorts spiraux pour l'horlogerie doit faire face à des contraintes souvent à première vue incompatibles :

- nécessité d'obtention d'une limite élastique élevée,
- facilité d'élaboration, notamment de tréfilage et de laminage,
- excellente tenue en fatigue,
- stabilité des performances dans le temps,
- faibles sections.

La réalisation de ressorts spiraux est en outre centrée sur le souci de la compensation thermique, de façon à garantir des performances chronométriques régulières. Il faut pour cela obtenir un coefficient thermoélastique proche de zéro. On recherche également à réaliser des ressorts spiraux présentant une sensibilité aux champs magnétiques limitée.

Il a été notamment proposé dans les documents WO2005/045532 A2 et WO2015/189278 A2 des ressorts spiraux réalisés en alliage de niobium-titane présentant un faible coefficient thermoélastique et réduisant la nécessité de thermo-compensation du ressort spiral.

Toute amélioration sur au moins l'un de ces points, et en particulier sur la sensibilité aux champs magnétiques limitée, la compensation thermique, et la facilité d'élaboration, notamment d'étirage, de tréfilage et de laminage, représente donc une avancée significative.

Résumé de l'invention

L'invention se propose de définir un procédé de fabrication adéquat pour un ressort spiral destiné à équiper un balancier d'un mouvement d'horlogerie. Ce procédé se base sur la sélection d'un matériau particulier.

À cet effet, la présente invention concerne un procédé de fabrication d'un ressort spiral qui comprend :

- une étape d'élaboration d'une ébauche dans un alliage de niobium et de titane constitué de :
- niobium : balance à 100% en poids,
- titane: entre 40 et 60% en poids,
- traces d'éléments sélectionnés parmi le groupe constitué de O, H, C, Fe, Ta, N, Ni, Si, Cu, Al, chacun desdits éléments étant présent dans une quantité comprise entre 0 et 1600 ppm en poids, la quantité totale constituée par l'ensemble desdits éléments étant comprise entre 0% et 0.3% en poids,
- une étape de trempe de type $\beta$ de ladite ébauche à un diamètre donné, de façon à ce que le titane dudit alliage soit essentiellement sous forme de solution solide avec le niobium en phase $\beta$ (structure cubique centrée), la teneur en titane en phase $\alpha$ (structure hexagonale compacte) étant inférieure ou égale à 5% en volume,
- au moins une étape de déformation dudit alliage alternée avec au moins une étape de traitement thermique de sorte que l'alliage de niobium et de titane obtenu présente une limite élastique supérieure ou égale à 600 MPa et un module d'élasticité inférieur ou égal à 100 GPa, une étape d'estrapadage pour former le ressort-spiral étant effectuée avant une dernière étape de traitement thermique.

Selon l'invention, le procédé comprend avant l'étape de déformation, une étape de dépôt, sur l'ébauche en alliage, d'une couche superficielle d'un matériau ductile choisi parmi le groupe comprenant le cuivre, le nickel, le cupro-nickel, le cupro-manganèse, l'or, l'argent, le nickel-phosphore Ni-P et le nickel-bore Ni-B, ladite couche superficielle de matériau ductile étant conservée sur le ressort spiral final obtenu, le coefficient thermoélastique de l'alliage de niobium et de titane étant adapté en conséquence.

Le ressort spiral selon l'invention est réalisé dans un alliage de niobium et de titane paramagnétique et présentant les propriétés mécaniques et le coefficient thermoélastique requis pour son utilisation en tant que ressort spiral pour balancier. Il est obtenu selon un procédé de fabrication qui permet de faciliter la mise en forme sous forme de fil de l'ébauche en alliage NbTi, et plus spécifiquement de faciliter l'étirage, le tréfilage, et le laminage et d'obtenir une section finale de fil parfaitement régulière.

Description détaillée des modes de réalisation préférés

L'invention concerne un ressort spiral destiné à équiper un balancier d'un mouvement d'horlogerie et réalisé dans un alliage de type binaire comportant du niobium et du titane.

Conformément à l'invention, le ressort spiral est réalisé dans un alliage de niobium et de titane constitué de :

- niobium : balance à 100% en poids,

  - titane : entre 40 et 60% en poids,
  - traces d'éléments sélectionnés parmi le groupe constitué de O, H, C, Fe, Ta, N, Ni, Si, Cu, Al, chacun desdits éléments étant présent dans une quantité comprise entre 0 et 1600 ppm en poids, la quantité totale constituée par l'ensemble desdits éléments étant comprise entre 0% et 0.3% en poids, ledit alliage présentant une limite élastique supérieure ou égale à 600 MPa et un module d'élasticité inférieur à 100 GPa.

Selon l'invention, ledit alliage NbTi est recouvert d'une couche superficielle d'un matériau ductile choisi parmi le groupe comprenant le cuivre, le nickel, le cupro-nickel, le cupro-manganèse, l'or, l'argent, le nickel-phosphore Ni-P et le nickel-bore Ni-B.

La couche superficielle de matériau ductile conservée permet d'obtenir une section finale de fil parfaitement régulière. Le matériau ductile peut être de préférence du cuivre ou de l'or.

D'une manière avantageuse, le ressort spiral peut comprendre, sur la couche superficielle de matériau ductile, une couche finale d'un matériau choisi parmi le groupe comprenant le cuivre, le nickel, le cupro-nickel, le cupro-manganèse, l'argent, le nickel-phosphore Ni-P, le nickel-bore Ni-B, l'or, pour autant que le matériau de la couche finale soit différent du matériau ductile de la couche superficielle, $Al_2O_3$, $TiO_2$, $SiO_2$ et AlO. Cette couche finale présente une épaisseur de 0.1 $\mu$m à 1 $\mu$m et permet de colorer le spiral ou d'obtenir une insensibilité au vieillissement climatique (température et humidité).

D'une manière avantageuse, l'alliage utilisé dans la présente invention comprend entre 40 et 49% en poids de titane, de préférence entre 44 et 49% en poids de titane, et plus préférentiellement entre 46% et 48% en poids de titane, et de préférence ledit alliage comprend plus de 46.5% en poids de titane et ledit alliage comprend moins de 47.5% en poids de titane.

Si le taux de titane est trop élevé, il apparait une phase martensitique entrainant des problèmes de fragilité de l'alliage lors de sa mise en œuvre. Si le taux de niobium est trop élevé, l'alliage sera trop mou. La mise au point de l'invention a permis de déterminer un compromis, avec un optimum entre ces deux caractéristiques voisin de 47 % en poids de titane.

Aussi, plus particulièrement, la teneur en titane est supérieure ou égale à 46.5% en poids par rapport au total de la composition.

Plus particulièrement, la teneur en titane est inférieure ou égale à 47.5% en poids par rapport au total de la composition.

D'une manière particulièrement avantageuse, l'alliage NbTi utilisé dans la présente invention ne comprend pas d'autres éléments à l'exception d'éventuelles et inévitables traces. Cela permet d'éviter la formation de phases fragiles.

Plus particulièrement, la teneur en oxygène est inférieure ou égale à 0.10% en poids du total, voire encore inférieure ou égale à 0.085% en poids du total.

Plus particulièrement, la teneur en tantale est inférieure ou égale à 0.10% en poids du total.

Plus particulièrement, la teneur en carbone est inférieure ou égale à 0.04% en poids du total, notamment inférieure ou égale à 0.020% en poids du total, voire encore inférieure ou égale à 0.0175% en poids du total.

Plus particulièrement, la teneur en fer est inférieure ou égale à 0.03% en poids du total, notamment inférieure ou égale à 0.025% en poids du total, voire encore inférieure ou égale à 0.020% en poids du total.

Plus particulièrement, la teneur en azote est inférieure ou égale à 0.02% en poids du total, notamment inférieure ou égale à 0.015% en poids du total, voire encore inférieure ou égale à 0.0075% en poids du total.

Plus particulièrement, la teneur en hydrogène est inférieure ou égale à 0.01% en poids du total, notamment inférieure ou égale à 0.0035% en poids du total, voire encore inférieure ou égale à 0.0005% en poids du total.

Plus particulièrement, la teneur en silicium est inférieure ou égale à 0.01% en poids du total.

Plus particulièrement, la teneur en nickel est inférieure ou égale à 0.01% en poids du total, notamment inférieure ou égale à 0.16% en poids du total.

Plus particulièrement, la teneur en matériau ductile, tel que le cuivre, dans l'alliage, est inférieure ou égale à 0.01% en poids du total, notamment inférieure ou égale à 0.005% en poids du total.

Plus particulièrement, la teneur en aluminium est inférieure ou égale à 0.01% en poids du total.

Le ressort spiral de l'invention a une limite élastique supérieure ou égale à 600 MPa.

De manière avantageuse, ce ressort spiral a un module d'élasticité inférieur ou égal à 100 GPa, et de préférence compris entre 60 GPa et 80 GPa.

En outre le ressort spiral selon l'invention présente un coefficient thermoélastique, dit aussi CTE, lui permettant de garantir le maintien des performances chronométriques malgré la variation des températures d'utilisation d'une montre incorporant un tel ressort spiral.

Pour former un oscillateur chronométrique répondant aux conditions COSC, le CTE de l'alliage doit être proche de zéro (± 10 ppm/°C) pour obtenir un coefficient thermique de l'oscillateur égal à ± 0.6 s/j/°C.

La formule qui lie le CTE de l'alliage et les coefficients de dilatation du spiral et du balancier est la suivante :

$$CT = \frac{dM}{dT} = \left( \frac{1}{2E}\frac{dE}{dT} - \beta + \frac{3}{2}\alpha \right) \times 86400 \frac{s}{j°C}$$

Les variables M et T sont respectivement la marche et la température. E est le module de Young du ressort-spiral, et, dans cette formule, E, $\beta$ et $\alpha$ s'expriment en °C$^{-1}$.

CT est le coefficient thermique de l'oscillateur, (1/E. dE/dT) est le CTE de l'alliage spiral, $\beta$ est le coefficient de dilatation du balancier et $\alpha$ celui du spiral.

Un CTE et donc un CT adéquats en fonction de la couche superficielle et de l'éventuelle couche finale sont facilement obtenus lors de la mise en oeuvre des différentes étapes du procédé de l'invention comme on le verra ci-dessous.

Selon une première variante, ledit alliage de niobium et de titane du ressort spiral est de structure monophasée dans laquelle le titane est essentiellement sous forme de solution solide avec le niobium en phase $\beta$, la teneur en titane en phase $\alpha$ étant inférieure ou égale à 10% en volume, de préférence inférieure ou égale à 5% en volume, et plus préférentiellement inférieure ou égale à 2.5% en volume.

Selon une seconde variante, ledit alliage de niobium et de titane du ressort spiral est de structure biphasée comprenant une solution solide de niobium avec du titane en phase $\beta$ et une solution solide de niobium avec du titane en phase $\alpha$, la teneur en titane en phase $\alpha$ étant supérieure à 10% en volume.

La présente invention concerne également un procédé de fabrication d'un ressort spiral en alliage de type binaire NbTi tel que défini ci-dessus, ledit procédé comprenant:

- une étape d'élaboration d'une ébauche dans un alliage de niobium et de titane constitué de :

  - niobium : balance à 100% en poids,
  - titane: entre 40 et 60% en poids,
  - traces d'éléments sélectionnés parmi le groupe constitué de O, H, C, Fe, Ta, N, Ni, Si, Cu, Al, chacun desdits éléments étant présent dans une quantité comprise entre 0 et 1600 ppm en poids, la quantité totale constituée par l'ensemble desdits éléments étant comprise entre 0% et 0.3% en poids,

- une étape de trempe de type $\beta$ de ladite ébauche à un diamètre donné, de façon à ce que le titane dudit alliage soit essentiellement sous forme de solution solide avec le niobium en phase $\beta$, la teneur en titane en phase $\alpha$ étant inférieure ou égale à 5% en volume, et plus préférentiellement inférieure ou égale à 2.5% en volume,
- au moins une étape de déformation dudit alliage alternée avec au moins une étape de traitement thermique de sorte que l'alliage de niobium et de titane obtenu présente une limite élastique supérieure ou égale à 600 MPa et un module d'élasticité inférieur ou égal à 100 GPa, une étape d'estrapadage pour former le ressort-spiral étant effectuée avant la dernière étape de traitement thermique, cette dernière étape permettant de fixer la forme du spiral et d'ajuster le coefficient thermoélastique,
- et, avant l'étape de déformation, une étape de dépôt, sur l'ébauche en alliage, d'une couche superficielle d'un matériau ductile choisi parmi le groupe comprenant le cuivre, le nickel, le cupro-nickel, le cupro-manganèse, l'or, l'argent, le nickel-phosphore Ni-P et le nickel-bore Ni-B, ladite couche superficielle de matériau ductile étant conservée sur le ressort spiral, le coefficient thermoélastique de l'alliage de niobium et de titane étant adapté en conséquence.

Comme on le verra ci-après, le coefficient thermoélastique de l'alliage de niobium et de titane peut être ajusté facilement en choisissant le taux de déformation et les traitements thermiques appropriés.

D'une manière avantageuse, l'épaisseur de la couche de matériau ductile déposée est choisie de sorte que le rapport surface de matériau ductile/surface de l'alliage NbTi pour une section de fil donnée est inférieur à 1, de préférence inférieur à 0.5, et plus préférentiellement compris entre 0.01 et 0.4.

Une telle épaisseur de matériau ductile, et notamment de cuivre, permet d'étirer, de tréfiler et de laminer aisément le matériau composite Cu/NbTi.

Le matériau ductile, de préférence du cuivre, est ainsi déposé à un moment donné pour faciliter la mise en forme du fil par étirage et tréfilage, de telle manière à ce qu'il en reste une épaisseur de préférence comprise entre 1 et 500 micromètres sur le fil au diamètre total de 0.2 à 1 millimètre.

En outre, la couche superficielle de matériau ductile conservée permet d'obtenir une section finale de fil parfaitement régulière.

L'apport de matériau ductile, notamment du cuivre, peut être galvanique, PVD ou CVD, ou bien mécanique, c'est alors une chemise ou un tube de matériau ductile tel que le cuivre qui est ajusté sur une barre d'alliage niobium-titane à un gros diamètre, puis qui est amincie au cours de la ou des étapes de déformation du barreau composite.

Le matériau ductile peut être de préférence du cuivre ou de l'or, déposé par voie galvanique, PVD ou CVD.

Le procédé de l'invention peut en outre comprendre une étape de dépôt, sur la couche superficielle de matériau ductile conservée, d'une couche finale d'un matériau choisi parmi le groupe comprenant $Al_2O_3$, $TiO_2$, $SiO_2$ et AIO, par PVD ou CVD. On peut également prévoir une couche finale d'or déposée par flash d'or galvanique si l'or n'a pas déjà été utilisé comme matériau ductile de la couche superficielle. On peut aussi utiliser le cuivre, le nickel, le cupro-nickel, le cupro-manganèse, l'argent, le nickel-phosphore Ni-P et le nickel-bore Ni-B pour la couche finale, pour autant que le matériau de la couche finale soit différent du matériau ductile de la couche superficielle.

Cette couche finale présente une épaisseur de 0.1 $\mu$m à 1 $\mu$m et permet de colorer le spiral ou d'obtenir une insensibilité au vieillissement climatique (température et humidité).

De préférence, l'étape de trempe $\beta$ est un traitement de mise en solution, avec une durée comprise entre 5 minutes et 2 heures à une température comprise entre 700°C et 1000°C, sous vide, suivie d'un refroidissement sous gaz.

Plus particulièrement encore, cette trempe bêta est un traitement de mise en solution, entre 5 minutes et 1 heure à 800°C sous vide, suivie d'un refroidissement sous gaz.

De préférence, le traitement thermique est réalisé pendant une durée comprise entre 1 heure et 80 heures, voire plus, de préférence entre 1 heure et 15 heures à une température comprise entre 350°C et 700°C. Plus préférentiellement, le traitement thermique est réalisé pendant une durée comprise entre 5 heures et 10 heures à une température comprise entre 350°C et 600°C. Encore plus préférentiellement, le traitement thermique est réalisé pendant une durée comprise entre 3 heures et 6 heures à une température comprise entre 400°C et 500°C.

Une étape de déformation désigne d'une manière globale un ou plusieurs traitements de déformation, qui peuvent comprendre le tréfilage et/ou le laminage. Le tréfilage peut nécessiter l'utilisation d'une ou plusieurs filières lors de la même étape de déformation ou lors de différentes étapes de déformation si nécessaire. Le tréfilage est réalisé jusqu'à l'obtention d'un fil de section ronde. Le laminage peut être effectué lors de la même étape de déformation que le tréfilage ou dans une autre étape de déformation ultérieure. Avantageusement, le dernier traitement de déformation appliqué à l'alliage est un laminage, de préférence à profil rectangulaire compatible avec la section d'entrée d'une broche d'estrapadage.

D'une manière particulièrement avantageuse, le taux de déformation total, le nombre de traitements thermiques ainsi que les paramètres des traitements thermiques sont choisis pour obtenir un ressort spiral présentant un coefficient thermoélastique le plus proche possible de 0. Par ailleurs, en fonction du taux de déformation total, du nombre de traitement thermique et des paramètres des traitements thermiques, on obtient un alliage NbTi monophasé ou biphasé.

Plus particulièrement, selon une première variante, le nombre d'étapes de traitement thermique et de déformation est limité de sorte que l'alliage de niobium et de titane du ressort spiral obtenu conserve une structure dans laquelle le titane dudit alliage est essentiellement sous forme de solution solide avec le niobium en phase $\beta$ (structure cubique centrée), la teneur en titane en phase $\alpha$ étant inférieure ou égale à 10% en volume, de préférence inférieure ou égale à 5% en volume, plus préférentiellement inférieure ou égale à 2.5% en volume.

De préférence, le taux de déformation total est compris entre 1 et 5, de préférence entre 2 et 5.

D'une manière particulièrement avantageuse, on utilise une ébauche dont les dimensions sont au plus proche des dimensions finales recherchées de manière à limiter le nombre d'étapes de traitement thermique et de déformation et conserver une structure essentiellement monophasée $\beta$ de l'alliage NbTi. La structure finale de l'alliage NbTi du ressort spiral peut être différente de la structure initiale de l'ébauche, par exemple la teneur en titane sous forme $\alpha$ peut avoir varié, l'essentiel étant que la structure finale de l'alliage NbTi du ressort spiral soit essentiellement monophasée, le titane dudit alliage étant essentiellement sous forme de solution solide avec le niobium en phase $\beta$, la teneur en titane en phase $\alpha$ étant inférieure ou égale à 10% en volume, de préférence inférieure ou égale à 5% en volume, plus préférentiellement inférieure ou égale à 2.5% en volume. Dans l'alliage de l'ébauche après la trempe $\beta$, la teneur en titane en phase $\alpha$ est de préférence inférieure ou égale à 5% en volume, plus préférentiellement inférieure ou égale à 2.5% en volume, voire voisine ou égale à 0.

Ainsi, selon cette variante, on obtient un ressort spiral réalisé dans un alliage NbTi présentant une structure essentiellement monophasée sous forme de solution solide $\beta$-Nb-Ti, la teneur en titane sous forme $\alpha$ étant inférieure ou égale à 10% en volume, de préférence inférieure ou égale à 5% en volume, plus préférentiellement inférieure ou égale à 2.5% en volume.

De préférence, le procédé comprend une seule étape de déformation avec un taux de déformation compris entre 1 et 5, de préférence entre 2 et 5.

Ainsi, un procédé particulièrement préféré de l'invention comprend, après l'étape de trempe β, l'étape de dépôt, sur l'ébauche en alliage, de la couche superficielle de matériau ductile, une étape de déformation incluant un tréfilage au moyen de plusieurs filières puis un laminage, une étape d'estrapadage puis une dernière étape de traitement thermique (appelée fixage).

Le procédé de l'invention peut en outre comprendre au moins une étape de traitement thermique intermédiaire, de sorte que le procédé comprend par exemple après l'étape de trempe β, l'étape de dépôt, sur l'ébauche en alliage, de la couche superficielle de matériau ductile, une première étape de déformation, une étape de traitement thermique intermédiaire, une seconde étape de déformation, l'étape d'estrapadage puis une dernière étape de traitement thermique.

Plus le taux de déformation après la trempe β est élevé, plus le coefficient thermique CT est positif. Plus le matériau est recuit après la trempe β, dans la gamme de température adéquate, par les différents traitements thermiques, plus le coefficient thermique CT devient négatif. Un choix approprié du taux de déformation et des paramètres des traitements thermiques permet de ramener l'alliage NbTi monophasé à un CTE proche de zéro, ce qui est particulièrement favorable.

Selon une seconde variante, on applique une succession de séquences d'une étape de déformation alternée avec une étape de traitement thermique, jusqu'à l'obtention d'un alliage de niobium et de titane de structure biphasée comprenant une solution solide de niobium avec du titane en phase β (structure cubique centrée) et une solution solide de niobium avec du titane en phase α (structure hexagonale compacte), la teneur en titane en phase α étant supérieure à 10% en volume.

Pour obtenir une telle structure biphasée, il est nécessaire de précipiter une partie de la phase α par des traitements thermiques, selon les paramètres indiqués ci-dessus, avec une forte déformation entre les traitements thermiques. De préférence, on applique toutefois des traitements thermiques plus longs que ceux utilisés pour obtenir un alliage de ressort monophasé, par exemple des traitements thermiques réalisés pendant une durée comprise entre 15 heures et 75 heures à une température comprise entre 350°C et 500°C. Par exemple on applique des traitements thermiques de 75h à 400h à 350°C, de 25h à 400°C ou de 18h à 480°C.

Dans cette seconde variante « biphasée », on utilise une ébauche qui présente, après la trempe β un diamètre beaucoup plus grand que celui de l'ébauche préparée pour la première variante « monophasée ». Ainsi, dans la seconde variante, on utilise par exemple une ébauche de 30 mm de diamètre après la trempe β, alors qu'on utilise, pour la première variante, une ébauche de 0.2 à 2.0 mm de diamètre après la trempe β

De préférence, dans ces séquences couplées de déformation-traitement thermique, chaque déformation est effectuée avec un taux de déformation compris entre 1 et 5, le cumul global des déformations sur l'ensemble de ladite succession de séquences amenant un taux total de déformation compris entre 1 et 14.

Le taux de déformation répond à la formule classique 2ln(d0/d), où d0 est le diamètre de la dernière trempe bêta ou de celui d'une étape de déformation, et d est le diamètre du fil écroui obtenu à l'étape de déformation suivante.

D'une manière avantageuse, le procédé comporte dans cette seconde variante entre trois et cinq séquences couplées de déformation-traitement thermique.

Plus particulièrement, la première séquence couplée de déformation-traitement thermique comporte une première déformation avec au moins 30 % de réduction de section.

Plus particulièrement, chaque séquence couplée de déformation-traitement thermique, autre que la première, comporte une déformation entre deux traitements thermiques avec au moins 25 % de réduction de section.

Dans cette seconde variante, l'alliage en phase β écroui présente un CT fortement positif, et la précipitation de la phase α qui possède un CT fortement négatif, permet de ramener l'alliage biphasé à un CTE proche de zéro, ce qui est particulièrement favorable.

Le procédé de l'invention permet la réalisation, et plus particulièrement la mise en forme, d'un ressort spiral pour balancier en alliage de type niobium-titane, typiquement à 47 % en poids de titane (40-60%), présentant une microstructure essentiellement monophasée de β-Nb-Ti dans laquelle le titane est sous forme de solution solide avec le niobium en phase β ou une microstructure biphasée lamellaire très fine comprenant une solution solide de niobium avec du titane en phase β et une solution solide de niobium avec du titane en phase a. De plus, le ressort spiral présente une section finale parfaitement régulière, sans irrégularité ni fil à la surface. L'alliage NbTi présente des propriétés mécaniques élevées, en combinant une limite élastique très élevée, supérieure à 600 MPa, et un module d'élasticité très bas, de l'ordre de 60 Gpa à 80 GPa. Cette combinaison de propriétés convient bien pour un ressort spiral.

Un tel alliage est connu et utilisé pour la fabrication de supraconducteurs, tels qu'appareils d'imagerie par résonance magnétique, ou accélérateurs de particules, mais n'est pas utilisé en horlogerie.

Un alliage de type binaire comportant du niobium et du titane, du type sélectionné ci-dessus pour la mise en œuvre de l'invention, présente également un effet similaire à celui de l' « Elinvar », avec un coefficient thermo-élastique pratiquement nul dans la plage de températures d'utilisation usuelle de montres, et apte à la fabrication de spiraux auto-compensateurs.

De plus, un tel alliage est paramagnétique.

**Revendications**

1. Procédé de fabrication d'un ressort spiral destiné à équiper un balancier d'un mouvement d'horlogerie, comprenant :

    - une étape d'élaboration d'une ébauche dans un alliage de niobium et de titane constitué de :
    - niobium : balance à 100% en poids,
    - titane: entre 40 et 60% en poids,
    - traces d'éléments sélectionnés parmi le groupe constitué de O, H, C, Fe, Ta, N, Ni, Si, Cu, Al, chacun desdits éléments étant présent dans une quantité comprise entre 0 et 1600 ppm en poids, la quantité totale constituée par l'ensemble desdits éléments étant comprise entre 0% et 0.3% en poids,
    - une étape de trempe de type β de ladite ébauche à un diamètre donné, de façon à ce que le titane dudit alliage soit essentiellement sous forme de solution solide avec le niobium en phase β, la teneur en titane en phase α étant inférieure ou égale à 5% en volume,
    - au moins une étape de déformation dudit alliage alternée avec au moins une étape de traitement thermique de sorte que l'alliage de niobium et de titane obtenu présente une limite élastique supérieure ou égale à 600 MPa et un module d'élasticité inférieur ou égal à 100 GPa, une étape d'estrapadage pour former le ressort-spiral étant effectuée avant la dernière étape de traitement thermique,

    **caractérisé en ce qu**'il comprend, avant l'étape de déformation, une étape de dépôt, sur l'ébauche en alliage, d'une couche superficielle d'un matériau ductile choisi parmi le groupe comprenant le cuivre, le nickel, le cupro-nickel, le cupro-manganèse, l'or, l'argent, le nickel-phosphore Ni-P et le nickel-bore Ni-B, ladite couche superficielle de matériau ductile étant conservée sur le ressort spiral, le coefficient thermoélastique de l'alliage de niobium et de titane étant adapté en conséquence.

2. Procédé de fabrication selon la revendication 1, **caractérisé en ce que** l'épaisseur de la couche de matériau ductile déposée est choisie de sorte que le rapport surface de matériau ductile/surface de l'alliage NbTi pour une section de fil donnée est inférieur à 1, de préférence inférieur à 0.5, et plus préférentiellement compris entre 0.01 et 0.4.

3. Procédé de fabrication selon l'une des revendications 1 et 2, **caractérisé en ce qu**'il comprend une étape de dépôt, sur la couche superficielle de matériau ductile conservée sur le ressort spiral, d'une couche finale d'un matériau choisi parmi le groupe comprenant le cuivre, le nickel, le cupro-nickel, le cupro-manganèse, l'argent, le nickel-phosphore Ni-P, le nickel-bore Ni-B, l'or, choisis différents du matériau ductile de la couche superficielle, $Al_2O_3$, $TiO_2$, $SiO_2$ et AlO.

4. Procédé selon l'une des revendications 1 à 3, **caractérisé en ce que** l'étape de déformation comprend un tréfilage et/ou un laminage.

5. Procédé selon la revendication 4, **caractérisé en ce que** le dernier traitement de déformation appliqué à l'alliage est un laminage.

6. Procédé selon l'une des revendications 1 à 5, **caractérisé en ce que** le taux de déformation total, le nombre de traitement thermique ainsi que les paramètres des traitements thermiques sont choisis pour obtenir un ressort spiral présentant un coefficient thermoélastique le plus proche possible de 0.

7. Procédé de fabrication selon l'une des revendications 1 à 6, **caractérisé en ce que** ladite étape de trempe β est un traitement de mise en solution, avec une durée comprise entre 5 minutes et 2 heures à une température comprise entre 700°C et 1000°C, sous vide, suivie d'un refroidissement sous gaz.

8. Procédé de fabrication selon l'une des revendications 1 à 7, **caractérisé en ce que** le traitement thermique est réalisé pendant une durée comprise entre 1 heure et 80 heures à une température comprise entre 350°C et 700°C.

9. Procédé de fabrication selon l'une des revendications 1 à 8, **caractérisé en ce que** le nombre d'étapes de traitement thermique et de déformation est limité de sorte que l'alliage de niobium et de titane du ressort spiral obtenu conserve une structure dans laquelle le titane dudit alliage est essentiellement sous forme de solution solide avec le niobium en phase β, la teneur en titane en phase α étant inférieure ou égale à 10% en volume.

10. Procédé selon la revendication 9, **caractérisé en ce qu'**il comprend une seule étape de déformation avec un taux de déformation compris entre 1 et 5, de préférence entre 2 et 5.

11. Procédé selon l'une des revendications 9 à 10, **caractérisé en ce qu'**il comprend après l'étape de trempe β, une étape de déformation, une étape d'estrapadage et une étape de traitement thermique.

12. Procédé selon la revendication 11, **caractérisé en ce qu'**il comprend une étape de traitement thermique intermédiaire.

13. Procédé de fabrication selon l'une des revendications 9 à 12, **caractérisé en ce que** le traitement thermique est réalisé pendant une durée comprise entre 5 heures et 10 heures à une température comprise entre 350°C et 600°C.

14. Procédé de fabrication selon la revendication 13, **caractérisé en ce que** le traitement thermique est réalisé pendant une durée comprise entre 3 heures et 6 heures à une température comprise entre 400°C et 500°C.

15. Procédé de fabrication selon l'une des revendications 1 à 8, **caractérisé en ce qu'**on applique une succession de séquences d'une étape de déformation alternée avec une étape de traitement thermique, jusqu'à l'obtention d'un alliage de niobium et de titane de structure biphasée comprenant une solution solide de niobium avec du titane en phase β et une solution solide de niobium avec du titane en phase α, la teneur en titane en phase α étant supérieure à 10% en volume.

16. Procédé de fabrication selon la revendication 15, **caractérisé en ce que** chaque déformation est effectuée avec un taux de déformation compris entre 1 et 5, le cumul global des déformations sur l'ensemble de ladite succession de séquences amenant un taux total de déformation compris entre 1 et 14.

17. Procédé de fabrication selon l'une des revendications 15 à 16, **caractérisé en ce que** le traitement thermique est réalisé pendant une durée comprise entre 15 heures et 75 heures à une température comprise entre 350°C et 500°C.

## Patentansprüche

1. Verfahren zur Herstellung einer Spiralfeder, mit der eine Unruh eines Uhrwerks auszustatten ist, umfassend:

- einen Schritt der Ausarbeitung eines Rohlings aus einer Legierung aus Niob und Titan, die gebildet ist aus:
- Niob: Ausgleich auf 100 Gew-%,
- Titan: zwischen 40 und 60 Gew-%,
- Spuren von Elementen, die aus der Gruppe ausgewählt sind, die gebildet ist aus O, H, C, Fe, Ta, N, Ni, Si, Cu und Al, wobei jedes dieser Elemente in einer Menge vorhanden ist, die zwischen 0 und 1600 Gew-ppm vorliegt, wobei die Gesamtmenge, die aus allen diesen Elementen besteht, zwischen 0 und 0,3 Gew-% liegt,
- einen Schritt des Typ-β-Abschreckens des Rohlings auf einen gegebenen Durchmesser, so dass das Titan der Legierung im Wesentlichen in Form einer festen Lösung mit dem Niob in der β-Phase vorliegt, wobei der Gehalt an Titan in der α-Phase kleiner oder gleich 5 Vol-% ist, und
- mindestens einen Schritt der Verformung der Legierung, der sich mit mindestens einem Schritt des Wärmebehandlung abwechselt, so dass die erhaltene Niob-Titan-Legierung eine Streckgrenze von 600 MPa oder mehr und ein Elastizitätsmodul von 100 GP a oder weniger aufweist, einen Schritt der Federwindung, um die Spiralfeder zu bilden bevor der letzte Wärmebehandlungsschritt ausgeführt wird,

**dadurch gekennzeichnet, dass** es vor dem Verformungsschritt einen Schritt umfasst, bei dem auf dem Legierungsrohling eine Oberflächenschicht aus einem duktilen Material abgeschieden wird, das aus der Gruppe gewählt ist, die Kupfer, Nickel, Kupfer-Nickel, Kupfer-Mangan, Gold, Silber, Nickel-Phosphor Ni-P und Nickel-Bor Ni-B enthält, wobei die Oberflächenschicht aus dem duktilen Material auf der Spiralfeder verbleibt, wobei der thermoelastische Koeffizient der Legierung aus Niob und Titan entsprechend angepasst wird.

2. Verfahren zur Herstellung nach Anspruch 1, **dadurch gekennzeichnet, dass** die Dicke der aufgetragenen Schicht aus dem duktilem Material so gewählt ist, dass das Verhältnis der Oberfläche des duktilen Materials zur Oberfläche der NbTi-Legierung für einen gegebenen Drahtquerschnitt kleiner als 1, vorzugsweise kleiner als 0,5 ist, und noch bevorzugter zwischen 0,01 und 0,4 liegt.

3. Verfahren zur Herstellung nach einem der Ansprüche 1 oder 2, **dadurch gekennzeichnet, dass** es einen Schritt des Ablagerns auf der auf der Spiralfeder beibehaltenen Oberflächenschicht aus dem duktilen Material einer letzten Schicht aus einem Material, das aus der Gruppe gewählt ist, die Kupfer, Nickel, Kupfer-Nickel, Kupfer-Mangan, Silber, Nickel-Phosphor NiP, Nickel-Bor Ni-B und Gold, die verschieden von dem duktilen Material der Oberflächenschicht gewählt sind, $Al_2O_3$, $TiO_2$, $SiO_2$ und AlO enthält, umfasst.

4. Verfahren nach einem der Ansprüche 1 bis 3, **dadurch gekennzeichnet, dass** der Verformungsschritt ein Drahtziehen und/oder ein Walzen umfasst.

5. Verfahren nach Anspruch 4, **dadurch gekennzeichnet, dass** die letzte Verformungsbehandlung, die auf die Legierung angewendet wird, ein Walzen ist.

6. Verfahren nach einem der Ansprüche 1 bis 5, **dadurch gekennzeichnet, dass** die Gesamtverformungsrate, die Anzahl der Wärmebehandlungen sowie die Parameter der Wärmebehandlungen so ausgewählt werden, dass eine Spiralfeder erhalten wird, die einen thermoelastischen Koeffizienten aufweist, der möglichst nahe bei 0 liegt.

7. Verfahren zur Herstellung nach einem der Ansprüche 1 bis 6, **dadurch gekennzeichnet, dass** der β-Abschreckschritt eine Behandlung des Bringens in Lösung während einer Dauer zwischen 5 Minuten und 2 Stunden bei einer Temperatur zwischen 700 °C und 1000 °C im Vakuum, gefolgt von einer Abkühlung unter Gas, ist.

8. Verfahren zur Herstellung nach einem der Ansprüche 1 bis 7, **dadurch gekennzeichnet, dass** die Wärmebehandlung während einer Zeitdauer zwischen 1 Stunde und 80 Stunden bei einer Temperatur zwischen 350 °C und 700 °C durchgeführt wird.

9. Verfahren zur Herstellung nach einem der Ansprüche 1 bis 8, **dadurch gekennzeichnet, dass** die Anzahl der Wärmebehandlungs- und Verformungsschritte so begrenzt ist, dass die Niob-Titan-Legierung der erhaltenen Spiralfeder eine Struktur beibehält, in der das Titan der Legierung im Wesentlichen in Form einer festen Lösung mit Niob in der β-Phase vorliegt, wobei der Gehalt an Titan in der α-Phase kleiner oder gleich 10 Vol-% beträgt.

10. Verfahren nach Anspruch 9, **dadurch gekennzeichnet, dass** es einen einzigen Verformungsschritt mit einem Verformungsrate zwischen 1 und 5, vorzugsweise zwischen 2 und 5, umfasst.

11. Verfahren nach einem der Ansprüche 9 bis 10, **dadurch gekennzeichnet, dass** es nach dem β-Abschreckschritt einen Verformungsschritt, einen Federwindungsschritt und einen Wärmebehandlungsschritt umfasst.

12. Verfahren nach Anspruch 11, **dadurch gekennzeichnet, dass** es einen Zwischenschritt der Wärmebehandlung umfasst.

13. Verfahren zur Herstellung nach einem der Ansprüche 9 bis 12, **dadurch gekennzeichnet, dass** die Wärmebehandlung während einer Zeitdauer zwischen 5 Stunden und 10 Stunden bei einer Temperatur zwischen 350 °C und 600 °C durchgeführt wird.

14. Verfahren zur Herstellung nach Anspruch 13, **dadurch gekennzeichnet, dass** die Wärmebehandlung während einer Zeitdauer zwischen 3 Stunden und 6 Stunden bei einer Temperatur zwischen 400 °C und 500 °C durchgeführt wird.

15. Verfahren zur Herstellung nach einem der Ansprüche 1 bis 8, **dadurch gekennzeichnet, dass** eine Folge angewendet wird von Sequenzen aus einem Schritt durch abwechselnde Verformung und Wärmebehandlung bis zum Erhalt einer Niob-Titan-Legierung mit einer zweiphasigen Struktur, die eine feste Lösung mit Niob und Titan in der β-Phase und eine feste Lösung mit Niob und Titan in der α-Phase enthält, wobei der Titangehalt in der α-Phase über 10 Vol-% liegt.

16. Verfahren zur Herstellung nach Anspruch 15, **dadurch gekennzeichnet, dass** jede Verformung mit einer Verformungsrate zwischen 1 und 5 durchgeführt wird, wobei die Gesamtkumulation der Verformungen über die gesamte Folge von Sequenzen zu einer Gesamtverformungsrate zwischen 1 und 14 führt.

**17.** Verfahren zur Herstellung nach einem der Ansprüche 15 bis 16, **dadurch gekennzeichnet, dass** die Wärmebehandlung während einer Zeitdauer zwischen 15 und 75 Stunden bei einer Temperatur zwischen 350 °C und 500 °C durchgeführt wird.

**Claims**

**1.** Method for manufacturing a balance spring intended to be fitted to a balance of a timepiece movement, including:

- a step of creating a blank from a niobium and titanium alloy containing:

  - niobium: the remainder to 100wt%,
  - titanium: between 40 and 60wt%,
  - traces of elements selected from the group formed of O, H, C, Fe, Ta, N, Ni, Si, Cu, Al, each of said elements being present in an amount comprised between 0 and 1600 ppm by weight, the total amount formed by all of said elements being comprised between 0 and 0.3wt%,

  - a step of β-quenching said blank with a given diameter, such that the titanium of said alloy is essentially in solid solution form with β-phase niobium, the α-phase titanium content being less than or equal to 5% by volume,
  - at least one deformation step of said alloy alternated with at least one heat treatment step such that the niobium and titanium alloy obtained has an elastic limit higher than or equal to 600 MPa and a modulus of elasticity lower than or equal to 100 GPa, a winding step to form the balance spring being performed prior to the final heat treatment step,

**characterized in that**, prior to the deformation step, the method includes a step of depositing, on the alloy blank, a surface layer of a ductile material chosen from the group including copper, nickel, cupronickel, cupro manganese, gold, silver, nickel phosphorus NiP and nickel boron NiB, said surface layer of ductile material being retained on the balance spring, the thermoelastic coefficient of the niobium and titanium alloy being adapted accordingly.

**2.** Manufacturing method according to claim 1, **characterized in that** the thickness of the deposited ductile material layer is chosen such that the ratio of the area of ductile material to the area of NbTi alloy for a given cross-section of wire is less than 1, preferably less than 0.5, and more preferably comprised between 0.01 and 0.4.

**3.** Manufacturing method according to any of claims 1 and 2, **characterized in that** the method includes a step of depositing, on the surface layer of ductile material retained on the balance spring, a final layer of a material chosen from the group containing copper, nickel, cupronickel, cupro manganese, silver, nickel phosphorus NiP, nickel-boron NiB, gold, chosen to be different from the ductile material of the surface layer, $Al_2O_3$, $TiO_2$, $SiO_2$ and AIO.

**4.** Method according to any of claims 1 to 3, **characterized in that** the deformation step includes a wire drawing and/or a rolling process.

**5.** Method according to claim 4, **characterized in that** the last deformation treatment applied to the alloy is a rolling process.

**6.** Method according to any of claims 1 to 5, **characterized in that** the total deformation rate, the number of heat treatments and the heat treatment parameters are chosen to obtain a balance spring having a thermoelastic coefficient as close as possible to 0.

**7.** Manufacturing method according to any of claims 1 to 6, **characterized in that** said β-quenching step is a solution treatment, with a duration comprised between 5 minutes and 2 hours at a temperature comprised between 700°C and 1000°C, under vacuum, followed by gas cooling.

**8.** Manufacturing method according to any of claims 1 to 7, **characterized in that** the heat treatment is performed for a duration of between 1 hour and 80 hours at a temperature comprised between 350°C and 700°C.

**9.** Manufacturing method according to any of claims 1 to 8, **characterized in that** the number of heat treatment and deformation steps is limited such that the niobium and titanium alloy of the balance spring obtained retains a structure in which the titanium of said alloy is essentially in solid solution form with β-phase niobium, the α-phase titanium content being less than or equal to 10% by volume.

10. Method according to claim 9 **characterized in that** the method includes a single deformation step with a deformation rate comprised between 1 and 5, preferably between 2 and 5.

11. Method according to any of claims 9 to 10, **characterized in that** after the β quenching step, the method includes a deformation step, a winding step and a heat treatment step.

12. Method according to claim 11, **characterized in that** the method includes an intermediate heat treatment step.

13. Manufacturing method according to any of claims 9 to 12, **characterized in that** the heat treatment is performed for a duration of between 5 hours and 10 hours at a temperature comprised between 350°C and 600°C.

14. Manufacturing method according to claim 13, **characterized in that** the heat treatment is performed for a duration of between 3 hours and 6 hours at a temperature comprised between 400°C and 500°C.

15. Manufacturing method according to any of claims 1 to 8, **characterized in that** there is applied a succession of sequences of a deformation step alternated with a heat treatment step, until a niobium and titanium alloy with two-phase microstructure is obtained comprising a solid solution of niobium with β-phase titanium and a solid solution of niobium with α-phase titanium, the α-phase titanium content being greater than 10% by volume.

16. Manufacturing method according to claim 15, **characterized in that** each deformation is performed with a deformation rate comprised between 1 and 5, the cumulative total of deformations over all of said succession of sequences leading to a total deformation rate comprised between 1 and 14.

17. Manufacturing method according to any of claims 15 to 16, **characterized in that** the heat treatment is performed for a duration of between 15 hours and 75 hours at a temperature comprised between 350°C and 500°C.

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2005045532 A2

- WO 2015189278 A2